(19) Europäisches Patentamt / European Patent Office / Office européen des brevets

(11) **EP 3 542 505 B1**

(12) **EUROPÄISCHE PATENTSCHRIFT**

(45) Veröffentlichungstag und Bekanntmachung des Hinweises auf die Patenterteilung:
**09.12.2020 Patentblatt 2020/50**

(51) Int Cl.:
*H04L 27/36* *(2006.01)*          *H03F 1/32* *(2006.01)*
*H03F 3/189* *(2006.01)*          *H03F 3/21* *(2006.01)*

(21) Anmeldenummer: **17797258.5**

(22) Anmeldetag: **24.10.2017**

(86) Internationale Anmeldenummer:
**PCT/EP2017/077160**

(87) Internationale Veröffentlichungsnummer:
**WO 2018/091237 (24.05.2018 Gazette 2018/21)**

(54) **BESTIMMUNG EINES ARBEITSPUNKTES EINES NICHTLINEAREN LEISTUNGSVERSTÄRKERS**

DETERMINATION OF AN OPERATING POINT OF A NONLINEAR POWER AMPLIFIER

DÉTERMINATION D'UN POINT DE FONCTIONNEMENT D'UN AMPLIFICATEUR DE PUISSANCE NON LINÉAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.11.2016 DE 102016122354**

(43) Veröffentlichungstag der Anmeldung:
**25.09.2019 Patentblatt 2019/39**

(73) Patentinhaber: **Universität der Bundeswehr München**
**85579 Neubiberg (DE)**

(72) Erfinder:
• **KNOPP, Andreas**
  **08645 Bad Elster (DE)**
• **SCHRAML, Matthias**
  **92703 Thumsenreuth (DE)**
• **SCHWARZ, Robert**
  **85540 Haar (DE)**
• **HOFMANN, Christian**
  **81825 München (DE)**

(74) Vertreter: **Michalski Hüttermann & Partner Patentanwälte mbB**
**Speditionstraße 21**
**40221 Düsseldorf (DE)**

(56) Entgegenhaltungen:
• **YITAO ZHANG AND KIYOMICHI ARAKI: "A Novel Predistorter Design for Nonlinear Power Amplifier with Memory Effects in OFDM Communication Systems Using Orthogonal Polynomials", IEICE TRANSACTIONS ON ELECTRONICS, INSTITUTE OF ELECTRONICS, Bd. E93C, Nr. 7, 1. Juli 2010 (2010-07-01) , Seiten 983-990, XP001557458, TOKYO, JP ISSN: 0916-8524, DOI: 10.1587/TRANSELE.E93.C.983**
• **HAO ZHI-YONG ET AL: "Study of engine noise based on independent component analysis", JOURNAL OF ZHEJIANG UNIVERSITY SCIENCE, Bd. 8, Nr. 5, 1. April 2007 (2007-04-01), Seiten 772-777, XP036034394, ZHEIJIANG UNIVERSITY PRESS, CN ISSN: 1673-565X, DOI: 10.1631/JZUS.2007.A0772 [gefunden am 2007-04-01]**
• **MAHDI MAJIDI ET AL: "Accurate analysis of spectral regrowth of nonlinear power amplifier driven by cyclostationary modulated signals", ANALOG INTEGRATED CIRCUITS AND SIGNAL PROCESSING,, Bd. 74, Nr. 2, 12. Dezember 2012 (2012-12-12), Seiten 425-437, XP035165822, KLUWER ACADEMIC PUBLISHERS, BO ISSN: 1573-1979, DOI: 10.1007/S10470-012-9986-5**

**Beschreibung**

GEBIET

Die vorliegende Erfindung betrifft die Bestimmung des Arbeitspunktes eines zumindest zeitweise in einem nichtlinearen Verstärkungsbereich betriebenen Leistungsverstärkers ("power amplifier"). Insbesondere betrifft die vorliegende Erfindung die Bestimmung des Arbeitspunktes eines nichtlinearen Hochleistungsverstärkers ("high power amplifier") mittels statistischer Auswertung eines durch den Hochleistungsverstärker verstärkten Mehrfachträgersignals ("multi-carrier signal").

HINTERGRUND

Beim Betreiben von Leistungsverstärkern in (stark) nichtlinearen Verstärkungsbereichen kann es zu Signalverzerrungen kommen, die die Signalqualität erheblich beeinträchtigen. Bspw. kann es beim Verstärken eines Mehrfachträgersignals durch einen, in einem stark nichtlinearen Verstärkungsbereich betriebenen Leistungsverstärker zu nicht vernachlässigbaren Intermodulationsprodukten kommen.

Zur Verhinderung von Signalverzerrungen, die die Signalqualität erheblich beeinträchtigen, wird daher oftmals danach gestrebt, den Arbeitspunkt eines Leistungsverstärkers unter einem bestimmten Schwellwert zu halten bzw. den Leistungsverstärker nicht in zu stark nichtlinearen Verstärkungsbereichen zu betreiben. In diesem Zusammenhang aus dem Stand der Technik bekannte Verfahren und Vorrichtungen sind jedoch oftmals aufwändig in der Implementierung und/oder vermeiden Signalverzerrungen, die die Signalqualität erheblich beeinträchtigen, nur ungenügend.

Der Artikel YITAO ZHANG AND KIYOMICHI ARAKI: "A Novel Predistorter Design for Nonlinear Power Amplifier with Memory Effects in OFDM Communication Systems Using Orthogonal Polynomials",IEICE TRANSACTIONS ON ELECTRONICS, INSTITUTE OF ELECTRONICS, Bd. E93C, Nr. 7, 1. Juli 2010 (2010-07-01), Seiten 983-990, bezieht sich auf ein Vorverzerrerkonzept mit einer Reihe von orthogonalen Polynomen, um die Konvergenzgeschwindigkeit und die Kompensationsqualität zu erhöhen.

Der Artikel HAO ZHI-YONG ET AL: "Study of engine noise based on independent component analysis",JOURNAL OF ZHEJIANG UNIVERSITY SCIENCE, Bd. 8, Nr. 5, 1. April 2007 (2007-04-01), Seiten 772-777, bezieht sich auf ein Verfahren, bei dem zur Analyse der akustischen Signale des Dieselmotors eine unabhängige Komponentenanalyse durchgeführt wurde. Zunächst wurde das Grundprinzip der unabhängigen Komponentenanalyse (ICA) überprüft. Das akustische Signal des Dieselmotors wurde in mehrere unabhängige Komponenten (ICs) zerlegt; Fourier-Transformation und Continuous Wavelet Transformation (CWT) wurden angewendet, um die unabhängigen Komponenten zu analysieren. Verschiedene Geräuschquellen des Dieselmotors wurden getrennt, basierend auf den Eigenschaften der verschiedenen Komponenten im Zeit-Frequenzbereich.

Der Artikel MAHDI MAJIDI ET AL: "Accurate analysis of spectral regrowth of nonlinear power amplifier driven by cyclostationary modulated signals",ANALOG INTEGRATED CIRCUITS AND SIGNAL PROCESSING,, Bd. 74, Nr. 2, 12. Dezember 2012 (2012-12-12), betrifft eine genaue analytische Expression, um das spektrale Nachwachsen am Ausgang eines nichtlinearen Leistungsverstärkers (PA) unter Verwendung der Kumulanten höherer Ordnung und der Poissonsummenformel zu berechnen. Diese PA wird von den gefilterten digital modulierten Signalen angesteuert. Um die Genauigkeit der Berechnungen zu verbessern, wird die Zyklosationarität des Eingangssignals berücksichtigt. Darüber hinaus werden geschlossene Ausdrücke für die 1-dB-Kompressions- und Sättigungspunkte in Abhängigkeit von den PA-Modellparametern, der Statistik des Eingangssignals höherer Ordnung und der Übertragungsfunktion des Pulsformungsfilters extrahiert. Darüber hinaus werden ein analytischer Ausdruck für die Nachbarkanalleistung (ACP) und ein geschlossener Ausdruck des ACP-Verhältnisses abgeleitet. Es folgt die Untersuchung des Einflusses der PA-Nichtlinearität auf die Leistung des Empfängers. Zur Überprüfung der Genauigkeit der abgeleiteten Ausdrücke werden Simulationsstudien durchgeführt. Es wird eine ausgezeichnete Übereinstimmung zwischen den Analyse- und Simulationsergebnissen erreicht.

ZUSAMMENFASSUNG

Es ist daher die Aufgabe der vorliegenden Erfindung, ein Verfahren und ein System bereitzustellen, die es ermöglichen, einen Arbeitspunkt eines zumindest zeitweise in einem nichtlinearen Verstärkungsbereich betriebenen Leistungsverstärkers zu bestimmen und insbesondere die mittlere Eingangsleistung des Leistungsverstärkers auf Basis des bestimmten Wertes anzupassen.

Die vorliegende Erfindung löst diese Aufgabe durch Bereitstellen eines Verfahrens und eines Systems zum Bestimmen eines Arbeitspunktes eines nichtlinearen Leistungsverstärkers.

Die Erfindung wird durch die unabhängigen Ansprüche definiert. Die abhängigen Ansprüche geben vorteilhafte Ausführungsformen an.

Die vorliegende Erfindung basiert insbesondere darauf, dass sich Signalverzerrungen, die aus unterschiedlichen Arbeitspunkten eines zumindest zeitweise in einem nichtlinearen Verstärkungsbereich betriebenen Leistungsverstärkers resultieren, hinsichtlich der Amplitudenverteilung der verzerrten Signale (messbar) unterscheiden. Wird somit ein durch eine Übertragungsstrecke den verzerrten Signalen additiv aufgeprägtes Gauß'sches Rauschen von den verzerrten Signalen separiert, kann aus den Amplitudenverteilungen der verzerrten Signale auf einen jeweiligen Verzerrungsgrad geschlossen werden. Basierend darauf kann bspw. der Arbeitspunkt des Leistungsverstärkers so angepasst werden, dass Signalverzerrungen, die die Signalqualität erheblich beeinträchtigen, verhindert werden, ohne die Ausgangsleistung des Leistungsverstärkers unnötig stark reduzieren zu müssen.

Ein erfindungsgemäßes Verfahren umfasst ein Bestimmen eines Wertes eines Maßes einer Abweichung einer Amplitudenverteilung eines durch einen zumindest zeitweise in einem nichtlinearen Verstärkungsbereich betriebenen Leistungsverstärker verstärkten Signals von einer Gauß-Verteilung und ein Steuern zumindest eines Teils eines auf dem Signal basierenden Kommunikationsprozesses auf Basis des bestimmten Wertes.

Dabei ist unter dem Begriff "Leistungsverstärker", wie er in der Beschreibung und den Ansprüchen verwendet wird, insbesondere ein elektronisches Gerät zu verstehen, welches eine Ausgangsleistung bereitstellt, die sich über eine geringere Eingangsleistung steuern lässt. Die Beziehung zwischen Eingangs- und Ausgangsleistung im Verstärkungsbereich (bei nominalem Betrieb) lässt sich dabei typischerweise durch eine Verstärkungskennlinie beschreiben, die jeder Eingangsleistung eine größere Ausgangsleistung zuordnet. Die Leistungsverstärkung nimmt dabei typischerweise bei Annäherung an einen Sättigungsbereich des Leistungsverstärkers mit zunehmender Eingangsleistung ab, wodurch ein nichtlinearer Verstärkungsbereich gebildet wird.

Ferner ist unter dem Begriff "Amplitudenverteilung", wie er in der Beschreibung und den Ansprüchen verwendet wird, insbesondere eine Verteilung von über einen vorbestimmten Zeitraum abgetasteten Amplitudenwerten des Signals, d. h. eine Verteilung einer vorbestimmten Anzahl an abgetasteten Amplitudenwerten zu verstehen. Ferner ist unter dem Begriff "Kommunikationsprozess", wie er in der Beschreibung und den Ansprüchen verwendet wird, insbesondere ein Prozess zum Übertragen von Signalen zwischen Kommunikationseinrichtungen zu verstehen, der typischerweise das Interpretieren der übertragenen Signale und somit das Erzeugen digitaler Daten auf Basis der übertragenen Signale einschließt.

Dadurch, dass der Wert eines Maßes der Abweichung der Amplitudenverteilung von einer Gauß-Verteilung bestimmt wird, spiegelt der bestimmte Wert die durch den Leistungsverstärker verursachte Signalverzerrung wieder, ist aber unabhängig von Gauß-verteilten Störungen, die das verstärkte Signal bei der Übertragung entlang einer Übertragungsstrecke verfälschen. Das Separieren der (das verstärkte Signal bei der Übertragung entlang der Übertragungsstrecke verfälschenden) Störungen ermöglicht es, die durch den Leistungsverstärker verursachte Signalverzerrung übertragungsstreckenunabhängig zu bestimmen.

Vorzugsweise umfasst das Verfahren ferner ein Anpassen einer mittleren Eingangsleistung des Leistungsverstärkers auf Basis des bestimmten Wertes.

Dies ermöglicht es, den Leistungsverstärker kontinuierlich in einem Verstärkungsbereich zu betreiben, der eine angemessene Ausgangsleistung bei zugleich akzeptabler Verzerrung ermöglicht. Die Erfindung ist diesbezüglich jedoch nicht beschränkt, da eine Vielzahl weiterer Verwendungen hinsichtlich des bestimmten Wertes möglich sind, wie bspw. das Prüfen des technischen Zustandes des Leistungsverstärkers und ein darauf basierendes Steuern des Kommunikationsprozesses, das Überwachen von Alterungsprozessen im Leistungsverstärker zur Korrektur und Optimierung von Linkbudgets und Verbindungsberechnungen, das Detektieren von unerwünschten Störungen, die in den Leistungsverstärker einkoppeln und bspw. ein darauf basierendes (temporäres) Umleiten von Kommunikationsströmen, etc.

Vorzugsweise ist das durch den Leistungsverstärker verstärkte Signal ein über eine störungsbehaftete Übertragungsstrecke übertragenes Signal und insbesondere ein Funksignal.

Dabei kann vermieden werden, dass, das verstärkte Signal verfälschende Störungen geschätzt oder gemessen werden müssen.

Vorzugsweise ist das durch den Leistungsverstärker verstärkte Signal ein Mehrfachträgersignal oder ein hochvalent moduliertes Einträgersignal.

Dabei ist unter dem Begriff "Mehrfachträgersignal", wie er in der Beschreibung und den Ansprüchen verwendet wird, insbesondere ein aus mehreren Teilsignalen unterschiedlicher Trägerfrequenzen bzw. unterschiedlicher Trägerfrequenzbereiche gebildetes Summensignal zu verstehen. Ferner ist unter dem Begriff "hochvalent moduliertes Einträgersignal", wie er in der Beschreibung und den Ansprüchen verwendet wird, insbesondere ein Einträgersignal mit mindestens 8, mindestens 16 oder mindestens 32 Konstellationspunkten zu verstehen.

Bei einem Leistungsverstärker, der ein Mehrfachträgersignal verstärkt, kann dabei bspw. durch das Anpassen der mittleren Eingangsleistung des Leistungsverstärkers das Entstehen von Intermodulationsprodukten vermieden oder auf ein für die avisierte Übertragungsqualität unschädliches Maß reduziert werden.

Vorzugsweise nimmt eine Linearität der Leistungsverstärkung des Leistungsverstärkers mit zunehmender Eingangsleistung des Leistungsverstärkers ab und das Anpassen der mittleren Eingangsleistung des Leistungsverstärkers auf Basis des bestimmten Wertes umfasst ein Reduzieren der mittleren Eingangsleistung des Leistungsverstärkers auf Basis des bestimmten Wertes.

Dadurch kann eine die Signalqualität erheblich beeinträchtigende Verzerrung auf Grund des Betreibens des Leistungsverstärkers mit einer zu hohen mittleren Eingangsleistung erkannt bzw. vermieden werden, da das Verstärkungsfenster auf einen Verstärkungsbereich begrenzt werden kann, in dem eine Abweichung von einer linearen Leistungsverstärkung einen vorbestimmten Wert nicht überschreitet.

In diesem Zusammenhang ist ferner anzumerken, dass eine Erhöhung des Arbeitspunktes in Richtung Sättigung eine größere Ausgangsleistung des Leistungsverstärkers und damit eine höhere Empfangsleistung ermöglicht. Wenn dabei aber Verzerrungen im Signal das Signal-zu-Rausch-Verhältnis (SNR) stärker reduzieren als der Gewinn an Empfangsleistung dieses erhöht, bringt die Maßnahme keine Vorteile. Vorteilhaft ist es somit, den Leistungsverstärker hinsichtlich des Signal-zu-Rausch-Verhältnis des empfangenen Signals in einem Optimum zu betreiben. Ein Ausplanen des Verstärkers ohne Reserven ist ferner nur bei Kenntnis des Arbeitspunktes des Verstärkers möglich. Ist dieser hingegen nicht bekannt, müssen Sicherheitsreserven belassen werden.

Vorzugsweise umfasst das Anpassen der mittleren Eingangsleistung des Leistungsverstärkers auf Basis des bestimmten Wertes ein Vergleichen des bestimmten Wertes mit einem oder mehreren vorbestimmten Werten.

Dabei können die vorbestimmten Werte sowohl durch Messung als auch durch Berechnung bzw. Simulation bestimmt werden. Insbesondere kann mittels Messung oder Berechnung ein Schwellwert bestimmt werden, dessen Überschreiten oder Unterschreiten eine Anpassung der mittleren Eingangsleistung auslöst.

Das Maß der Abweichung basiert der Amplitudenverteilung auf Kumulanten, deren Ordnung größer als 2 und gerade ist.

Kumulanten, deren Ordnung größer als 2 ist, sind unabhängig von dem Einfluss einer Gauß-verteilten Störung des verstärkten Signals. Zudem sind gerade Kumulanten auch bei um Null symmetrischen Amplitudenverteilungen ungleich Null.

Vorzugsweise hängt das Maß der Abweichung der Amplitudenverteilung linear von einem Verhältnis einer Potenz einer Kumulante einer ersten geraden Ordnung zu einer Potenz einer Kumulante einer zweiten geraden Ordnung ab, wobei die Potenz der ersten Kumulante mal der Ordnung der ersten Kumulante der Potenz der zweiten Kumulante mal der Ordnung der zweiten Kumulante entspricht.

Dadurch heben sich die jeweiligen Dämpfungsfaktoren gegenseitig vollständig auf, wodurch das Verhältnis dämpfungsunabhängig wird.

Vorzugsweise hängt das Maß der Abweichung der Amplitudenverteilung linear von einem Verhältnis einer Kumulanten einer ersten geraden Ordnung zu einem Quadrat einer Kumulanten einer zweiten geraden Ordnung ab, wobei die erste gerade Ordnung dem Doppelten der zweiten geraden Ordnung entspricht.

Dadurch die eine Abhängigkeit des bestimmten Wertes von der Dämpfung des verstärkten Signals entlang der Übertragungsstrecke verhindert werden und zudem eine lineare Abhängigkeit zwischen dem bestimmten Wert und dem Arbeitspunkt erzielt werden.

Vorzugsweise ist die erste gerade Ordnung 8 und die zweite gerade Ordnung 4.

Dadurch finden Kumulanten möglichst geringer Ordnung Verwendung, was das Bestimmen der verwendeten Kumulanten vereinfacht und den Aufwand beim Anwenden des Verfahrens reduziert.

Ein erfindungsgemäßes System zum Bestimmen eines Arbeitspunktes eines nichtlinearen Leistungsverstärkers umfasst eine Empfangseinheit, eingerichtet zum Empfangen eines durch den Leistungsverstärker verstärkten Signals, und eine Recheneinheit, eingerichtet zum Bestimmen eines Wertes eines Maßes einer Abweichung einer Amplitudenverteilung des empfangenen Signals von einer Gauß-Verteilung, wobei zumindest ein Teil eines auf dem Signal basierenden Kommunikationsprozesses auf Basis des bestimmten Wertes gesteuert wird und wobei das Maß der Abweichung der Amplitudenverteilung auf Kumulanten basiert, deren Ordnung größer als 2 und gerade ist.

Dabei ist unter dem Begriff "nichtlinearer Leistungsverstärker", wie er in der Beschreibung und den Ansprüchen verwendet wird, insbesondere ein Leistungsverstärker zu verstehen, dessen Verstärkungskennlinie in einem nominellen Verstärkungsbereich des Leistungsverstärkers zumindest abschnittsweise nichtlinear ist.

Ferner ist unter dem Begriff "Recheneinheit", wie er in der Beschreibung und den Ansprüchen verwendet wird, insbesondere eine mit einem Prozessor versehene Einheit zu verstehen, wie bspw. ein Microcontroller, ein digitaler Signalprozessor oder ein Field Programmable Gate Array.

Vorzugsweise umfasst das System den Leistungsverstärker, wobei das System dazu eingerichtet ist, eine mittlere Eingangsleistung des Leistungsverstärkers auf Basis des bestimmten Wertes zu steuern.

Dadurch kann ein Betreiben des Leistungsverstärkers in einem zu stark nichtlinearen Verstärkungsbereich vermieden werden.

KURZBESCHREIBUNG DER ZEICHNUNGEN

Die Erfindung wird nachfolgend in der detaillierten Beschreibung anhand von Ausführungsbeispielen erläutert, wobei auf Zeichnungen Bezug genommen wird, in denen:

Fig. 1    eine schematische Ansicht einer Ausführungsform des erfindungsgemäßen Systems;

Fig. 2    eine schematische Ansicht einer ersten Vorrichtung, die Teile des erfindungsgemäßen Systems enthalten kann;

Fig. 3    eine schematische Ansicht einer zweiten Vorrichtung, die Teile des erfindungsgemäßen Systems enthalten kann;

Fig. 4    eine schematische Ansicht einer dritten Vorrichtung, die Teile des erfindungsgemäßen Systems enthalten kann;

Fig. 5    ein Flussdiagramm des erfindungsgemäßen Verfahrens;

Fig. 6    eine Kurve eines Ausgangs-Backoffs ("output backoff", *OBO*) über einem Maß einer Abweichung einer Amplitudenverteilung eines durch den Leistungsverstärker verstärkten Signals von einer Gauß-Verteilung für verschiedene, mittels einer Monte-Carlo-Simulation erzeugte Signale;

Fig. 7    eine Kurve des Ausgangs-Backoffs über einem Maß einer Abweichung einer Amplitudenverteilung eines durch den Leistungsverstärker verstärkten Signals von einer Gauß-Verteilung zeigt, die auf mittels Simulation erzeugten Zufallsdatensequenzen basieren; und

Fig. 8    eine Kurve des mittleren Fehlerquadrats einer Arbeitspunktschätzung für unterschiedliche Arbeitspunktwerte über der Anzahl von für die Schätzung verwendeten Amplitudenwerten zeigt.

Dabei sind in den Zeichnungen gleiche Elemente durch identische Bezugszeichen gekennzeichnet.

## DETAILLIERTE BESCHREIBUNG

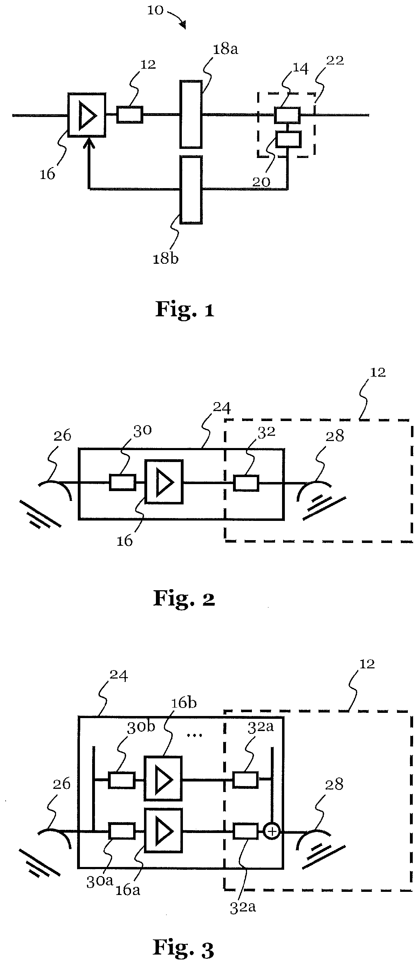

Fig. 1 zeigt eine schematische Ansicht eines Kommunikationssystems 10. Das Kommunikationssystem 10 umfasst eine Sendeeinheit 12 und eine Empfangseinheit 14. Die Sendeeinheit 12 überträgt ein durch einen Leistungsverstärker 16 (bspw. eine Wanderfeldröhre) verstärktes Signal über eine erste Übertragungsstrecke 18a an die Empfangseinheit 14. Die Empfangseinheit 14 stellt das empfangene Signal bzw. Teile des empfangenen Signals (bspw. abgetastete Signal-Amplitudenwerte $S_i$) einer Recheneinheit 20 zur Verfügung. Empfangseinheit 14 und Recheneinheit 20 können ein System 22 zum Bestimmen des Arbeitspunktes des Leistungsverstärkers 16 bilden, wobei, wie in Fig. 1 durch einen Pfeil angedeutet, die mittlere Eingangsleistung des Leistungsverstärker 16 auf Basis des bestimmten Arbeitspunktes angepasst bzw. gesteuert werden kann.

Sendeeinheit 12 und Leistungsverstärker 16 können, wie in Fig. 2 gezeigt, in einer Vorrichtung 24, wie bspw. einem Satelliten oder einer fliegenden Kommunikationsplattform angeordnet sein. Die Vorrichtung 24 kann eine Empfangsantenne 26 und eine Sendeantenne 28 umfassen. Ein von der Empfangsantenne 26 empfangenes (Mehrfachträger-)Signal kann über ein mit der Empfangsantenne 26 verbundenes erstes Filter 30, wie bspw. ein erstes Bandpassfilter bzw. einen "Input Multiplexer", an den Leistungsverstärker 16 weitergeleitet werden. Ferner kann das durch den Leistungsverstärker 16 verstärkte (Mehrfachträger-)Signal über ein mit dem Leistungsverstärker 16 verbundenes zweites Filter 32, wie bspw. ein zweites Bandpassfilter bzw. einen "Output Multiplexer", an die Sendeantenne 28 weitergeleitet werden.

Die Sendeantenne 28 kann das verstärkte und (optional) bandpassgefilterte Signal an die Empfangseinheit 14 übertragen, die ein Filter, wie bspw. ein Bandpassfilter, einen linearen Leistungsverstärker und eine Empfangsantenne umfassen kann oder über ein Filter, wie bspw. ein Bandpassfilter (nicht gezeigt) und einen linearen Leistungsverstärker (nicht gezeigt) mit einer Empfangsantenne (nicht gezeigt) verbunden sein kann. Ferner kann die Vorrichtung 24 eine Steuereinheit (nicht gezeigt) zum Anpassen bzw. Steuern der mittleren Eingangsleistung des Leistungsverstärkers 16 umfassen, die dazu eingerichtet ist, über die Empfangsantenne 26 Steuerdaten (bspw. von dem System 22) zu empfangen und auf Basis der Steuerdaten die mittlere Eingangsleistung des Leistungsverstärkers 16 anzupassen bzw. zu steuern.

Wie in Fig. 3 gezeigt, kann die Vorrichtung 24 mehrere Leistungsverstärker 16a, 16b, etc. und optional mehrere erste Filter 30a, 30b, etc. (bspw. erste Bandpassfilter) und zweite Filter 32a, 32b, etc. (bspw. zweite Bandpassfilter) umfassen, wobei ein von der Empfangsantenne 26 empfangenes Mehrfachträgersignal durch die ersten Filter 30a, 30b, etc. aufgespalten und durch die Leistungsverstärker 16a, 16b, etc. verstärkt werden kann. Die verstärkten Signale können (optional) durch die zweiten Filter 32a, 32b, etc. gefiltert, durch einen Addierer aufsummiert und als verstärktes Mehrfachträgersignal über die Sendeantenne 28 an die Empfangseinheit 14 übertragen werden.

Ferner kann zwischen den ersten Filtern 30a, 30b, etc. und den Leistungsverstärkern 16a, 16b, etc. noch ein Eingangsnetzwerk (nicht gezeigt) vorgesehen sein. Das Eingangsnetzwerk kann eine Vielzahl an Signalsplittern und Signalkombinierern umfassen, wodurch verschiedenste Teilsignale und Teilsignalkombinationen des Mehrfachträgersignals (ggf. mit unterschiedlichen Gewichtungsfaktoren) an die Leistungsverstärker 16a, 16b, etc. verteilt werden können. Zwischen den Leistungsverstärkern 16a, 16b, etc. und den zweiten Filtern 32a, 32b, etc. kann ferner ein zu dem Eingangsnetzwerk inverses Ausgangsnetzwerk (nicht gezeigt) vorgesehen sein, in dem die von den Leistungsverstärkern 16a, 16b, etc. verstärkten Teilsignale oder Teilsignalkombinationen wieder addiert werden können. Eingangsnetzwerk, Leistungsverstärker 16a, 16b, etc. und Ausgangsnetzwerk können bspw. als Multiportverstärker (MPA) ausgebildet sein.

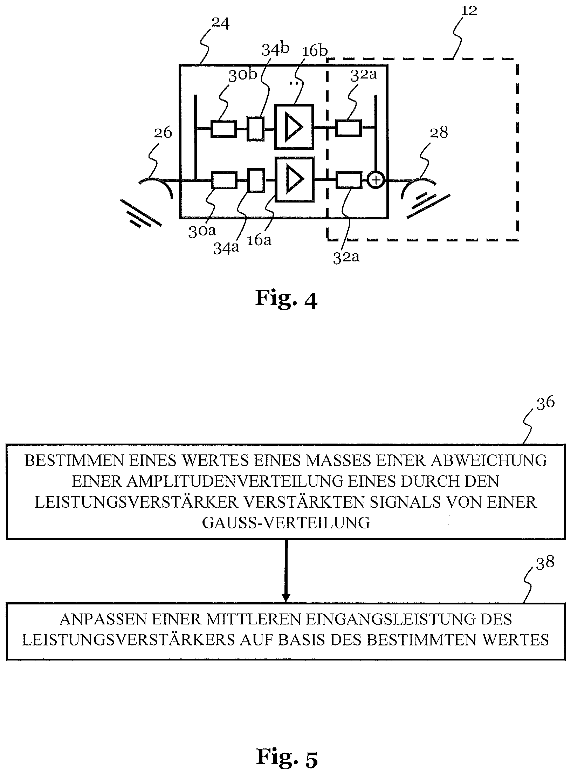

Ferner kann, wie in Fig. 4 gezeigt, zwischen dem ersten Filter 30a und dem Leistungsverstärker 16a eine Signalverarbeitungseinheit 34a vorgesehen sein, die das gefilterte analoge Signal interpretiert (bspw. als ein Phasenumtastungs-Signal, PSK-Signal, ein Amplitudenumtastungssignal, ASK-Signal, ein Quadraturamplitudenmodulationssignal, QAM-Signal, wie bspw. ein 4-QAM-Signal, ein 16-QAM-Signal, ein 64-QAM-Signal, ein 256-QAM-Signal, etc., oder ein Amplitudenumgetastetes Phasenmodulationssignal, APSK) und in entsprechende digitale Daten umwandelt. Optional kann die Signalverarbeitungseinheit 34a dazu eingerichtet sein, eine Vorwärtsfehlerkorrektur durchzuführen. Aus den digitalen Daten kann die Signalverarbeitungseinheit 34a (mittels Phasenumtastung, PSK, Amplitudenumtastung, ASK, Quadraturamplitudenmodulation, QAM, oder Amplitudenumgetasteter Phasenmodulation, APSK) ein analoges Signal erzeugen, das an den Leistungsverstärker 16a weitergeleitet wird. Wie in Fig. 4 gezeigt, können den Leistungsverstärkern 16b, etc. ebenfalls entsprechende Signalverarbeitungseinheiten 34b, etc. vorgeschaltet sein, die analog zur beschriebenen Signalverarbeitungseinheit 34a das jeweilige analoge Signal entstören bzw. "auffrischen".

Die Signalverarbeitungseinheit 34a kann ferner dazu eingerichtet sein, eine mittlere Eingangsleistung des Leistungsverstärkers 16a oder aller Leistungsverstärker 16a, 16b, etc. auf Basis des empfangenen Signals anzupassen bzw. zu steuern. Ebenso kann jede Signalverarbeitungseinheit 34a, 34b, etc. dazu eingerichtet sein, eine mittlere Eingangsleistung des an die jeweilige Signalverarbeitungseinheit 34a, 34b, etc. angeschlossenen Leistungsverstärkers 16a, 16b, etc. auf Basis des empfangenen Signals anzupassen bzw. zu steuern. Zudem kann, wie in Zusammenhang mit Fig. 2 erläutert, eine Steuereinheit (nicht gezeigt) vorgesehen sein, die von einer der Signalverarbeitungseinheiten 34a, 34b, etc. oder einer zusätzlichen Signalverarbeitungseinheit (nicht gezeigt) Daten empfängt und auf Basis der empfangenen Daten die mittlere Eingangsleistung eines oder aller Leistungsverstärker 16a, 16b, etc. anpasst bzw. steuert.

Das empfangene Signal, auf Basis dessen die mittlere Eingangsleistung des Leistungsverstärkers 16 bzw. eines oder aller Leistungsverstärker 16a, 16b, etc. angepasst bzw. gesteuert wird, kann, wie in Zusammenhang mit Fig. 1 erwähnt, auf dem bestimmten Arbeitspunkt des Leistungsverstärkers 16 bzw. auf dem/den bestimmten Arbeitspunkt(en) eines oder aller Leistungsverstärker 16a, 16b, etc. basieren. Dazu kann die in Fig. 1 gezeigte Recheneinheit 20, wie in Schritt 36 des Flussdiagramms in Fig. 5 gezeigt, dazu eingerichtet sein, einen Wert eines Maßes einer Abweichung einer Amplitudenverteilung eines der Recheneinheit 20 durch die Empfangseinheit 14 bereitgestellten, (optional) (bandpass-) gefilterten Signals von einer Gauß-Verteilung zu bestimmen. Bspw. kann die Recheneinheit 20 dazu eingerichtet sein, hinsichtlich des bereitgestellten Signals einen Wert einer Kumulante gerader Ordnung größer als 2 zu schätzen. Z. b. kann die Recheneinheit 20 dazu eingerichtet sein, einen oder mehrere Schätzwerte hinsichtlich einer oder mehrerer der Kumulanten:

- vierter Ordnung $\hat{\kappa}_4 = \hat{\mu}_4 - 3(\hat{\mu}_2)^2$,
- sechster Ordnung $\hat{\kappa}_6 = \hat{\mu}_6 - 15\hat{\mu}_4\hat{\mu}_2 - 10(\hat{\mu}_3)^2 + 30(\hat{\mu}_2)^3$,
- achter Ordnung $\hat{\kappa}_8 = \hat{\mu}_8 - 28\hat{\mu}_6\hat{\mu}_2 - 35(\hat{\mu}_4)^2 + 420\hat{\mu}_4(\hat{\mu}_2)^2 - 630(\hat{\mu}_2)^4$,
- etc.,

auf Basis einer Vielzahl diskreter Signal-Amplitudenwerten $S_i$ des bereitgestellten Signals mit $\hat{\mu}_a = \sum_{i=1}^{N} S_i^a$ (unter der Annahme, dass der Mittelwert der diskreten Signal-Amplitudenwerte $S_i$ gleich Null ist) zu schätzen.

Ferner kann die Recheneinheit 20 dazu eingerichtet sein, in Hinblick auf das bereitgestellte Signal einen Wert eines Quotienten einer Kumulante einer ersten geraden Ordnung größer als 2 und dem Quadrat einer Kumulante einer zweiten geraden Ordnung größer als 2 zu schätzen, wobei die erste Ordnung dem Doppelten der zweiten Ordnung entspricht. Dadurch kann ein von einer (linearen) Signaldämpfung entlang der ersten Übertragungsstrecke 18a (und der optionalen linearen Signalverstärkung in dem System 22) unabhängiger Wert bestimmt werden. Z. B. bestimmt die Recheneinheit 20 einen Schätzwert des Quotienten der Kumulante achter Ordnung und dem Quadrat der Kumulante vierter Ordnung $\hat{Q}_{8,4} = \frac{\hat{\kappa}_8}{(\hat{\kappa}_4)^2}$. Dadurch ist obige Bedingung unter Verwendung der kleinstmöglichen Kumulanten erfüllt, wodurch der Aufwand beim Bestimmen des Wertes durch die Recheneinheit 20 geringgehalten werden kann. Allerdings versteht es sich, dass auch Schätzwerte auf Basis anderer Kumulanten-Quotienten möglich sind, bei denen ein von der Signaldämpfung unabhängiger Wert bestimmt wird. Insbesondere, indem Dividend und Divisor, wie im vorhergehenden Beispiel gezeigt, so gewählt sind, dass sich die jeweiligen Dämpfungsfaktoren gegenseitig vollständig aufheben (d. h.

herausgekürzt werden könnten), wodurch der Quotient dämpfungsunabhängig wird. Dies kann insbesondere dadurch erreicht werden, dass das Produkt aus Ordnung und Hochzahl bei Dividend und Divisor übereinstimmt.

Wie in Schritt 38 des Flussdiagramms in Fig. 5 gezeigt, kann der bestimmte Wert dazu verwendet werden, eine mittlere Eingangsleistung des Leistungsverstärkers 16 bzw. eines oder aller Leistungsverstärker 16a, 16b, etc. anzupassen bzw. zu steuern. Dazu kann die Recheneinheit 20 dazu eingerichtet sein, bspw. einen Schwellenwert hinsichtlich des Arbeitspunktes des Leistungsverstärkers 16 bzw. eines oder aller Leistungsverstärker 16a, 16b, etc., welcher einem gewünschten Ausgangs-Backoff bzw. gewünschten Ausgangs-Backoffs entspricht, zu speichern. Wird dieser Schwellenwert überschritten, kann die Recheneinheit 20 dazu eingerichtet sein zu signalisieren, dass die mittlere Eingangsleistung des Leistungsverstärkers 16 bzw. die mittlere Eingangsleistung eines oder aller Leistungsverstärker 16a, 16b, etc. zu reduzieren ist.

Umgekehrt kann, wenn der Schwellenwert unterschritten wird, die Recheneinheit 20 dazu eingerichtet sein zu signalisieren, dass die mittlere Eingangsleistung des Leistungsverstärkers 16 bzw. die mittlere Eingangsleistung eines oder aller Leistungsverstärker 16a, 16b, etc. erhöht werden kann. Dazu kann die Recheneinheit 20, wie in Fig. 1 gezeigt, ein Signal, welches ein Reduzieren oder ein mögliches Erhöhen einer mittleren Eingangsleistung signalisiert, über die zweite Übertragungsstrecke 18b an den Leistungsverstärker 16 bzw. die Empfangsantenne 26 senden. In diesem Zusammenhang sei angemerkt, dass insbesondere im Falle einer bidirektionalen Kommunikation zwischen der Sendeeinheit 12 und der Empfangseinheit 14 die erste Übertragungsstrecke 18a und die zweite Übertragungsstrecke 18b gleich sein können.

Ferner kann aus dem bestimmten Wert ein Arbeitspunkt des Leistungsverstärkers 16 bzw. der/die Arbeitspunkt(e) eines oder aller Leistungsverstärker 16a, 16b, etc. bestimmt werden. Dazu kann bspw. der bestimmte Wert mit tabellarischen Werten verglichen werden und bei einer Übereinstimmung ein dem übereinstimmenden Wert zugeordneter Ausgangs-Backoff bzw. Ausgangs-Backoffs (im Rahmen der Genauigkeit des Prozesses) als Arbeitspunkt des Leistungsverstärkers 16 bzw. als Arbeitspunkt(e) eines oder aller Leistungsverstärker 16a, 16b, etc. bestimmt werden. Der Schwellenwert und die tabellarischen Werte können z. B. mittels einer oder mehrerer Messungen bestimmt werden, indem für verschiedene bekannte Ausgangs-Backoffs des Leistungsverstärkers 16 bzw. eines oder aller Leistungsverstärker 16a, 16b, etc., ein durch den Leistungsverstärker 16 bzw. durch einen oder alle Leistungsverstärker 16a, 16b, etc. verstärktes Signal, wie oben beschrieben, durch Schätzen einer oder mehrerer Kumulanten analysiert wird und die durch die Analyse ermittelten Werte den jeweiligen Ausgangs-Backoffs zugeordnet werden.

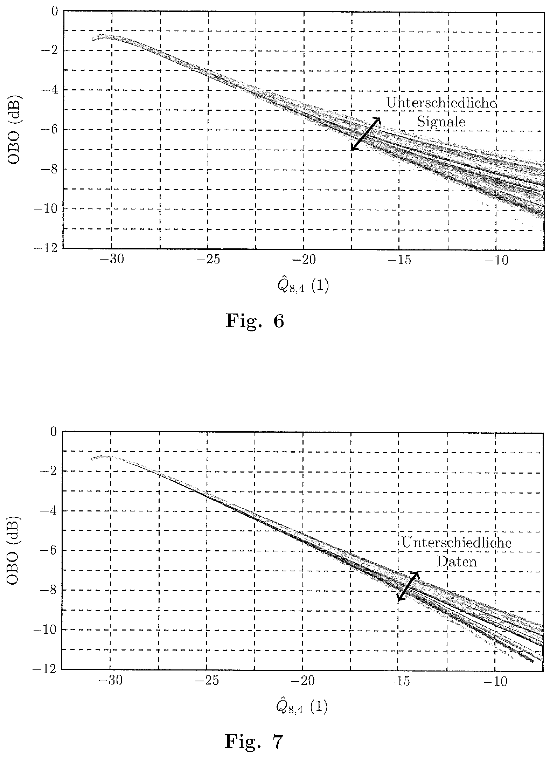

Der Schwellenwert und die tabellarischen Werte können auf Basis eines Modells des Kommunikationssystems 10 (und insbesondere der Verstärkungskurve des Leistungsverstärkers 16 bzw. der Verstärkungskurve(n) eines oder aller Leistungsverstärker 16a, 16b, etc.) berechnet werden. Fig. 6 zeigt dazu einen auf Basis eines Modells des Kommunikationssystems 10 berechneten Zusammenhang zwischen Ausgangs-Backoff (*OBO*) und $\hat{Q}_{8,4} = \frac{\hat{\kappa}_8}{(\hat{\kappa}_4)^2}$ für ver-schiedene, mittels einer Monte-Carlo-Simulation erzeugte und gemäß einer nichtlinearen Verstärkungskurve verstärkte Mehrfachträgersignale umfassend $15 \leq L \leq 40$ Träger, bei einer Abtastrate von 40 MHz und $K$ = 20.000 Abtastwerten.

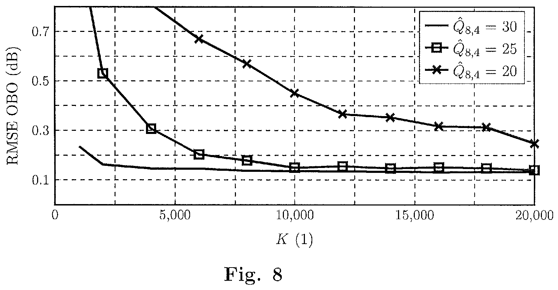

Wie in Fig. 6 gezeigt, konvergieren die Werte für $\hat{Q}_{8,4}$ für größere Ausgangs-Backoffs *(OBOs)*. Dies zeigt beispielhaft, dass bei fehlender Information über das von der Empfangseinheit 14 empfangene Signal eine "Blindschätzung" des Schwellenwerts und der (relevanten) tabellarischen Werte für entsprechend große Ausgangs-Backoffs *(OBO)* mit ausreichender Genauigkeit möglich ist. Zudem kann durch die Verwendung einer größeren Anzahl an Abtastwerten und mehrerer voneinander statistisch unabhängiger Abtastwertreihen die Genauigkeit der in Fig. 6 gezeigten Kurve weiter verbessert werden. Dazu zeigt Fig. 8 das mittlere Fehlerquadrat der OBO-Schätzung für unterschiedliche Werte für $\hat{Q}_{8,4}$ über der Anzahl der für die Schätzung verwendeten Abtastwerte.

Wenn zusätzliche Informationen über das Signal verfügbar sind können diese verwendet werden, um den Zusammenhang zwischen Ausgangs-Backoff (*OBO*) und $\hat{Q}_{8,4} = \frac{\hat{\kappa}_8}{(\hat{\kappa}_4)^2}$ in Situationen zu berechnen, in denen die obige "Blindschätzung" keine ausreichend genauen Werte liefert. Lässt sich das zu verstärkende Signal *S'* bspw. durch

$$S' = \sum_{l=1}^{L} Re \left\{ A_l \sum_{n=-\infty}^{\infty} d_l'(n) \, h_l(kT - nT_{Sl}) e^{j2\pi(f_0 + \Delta f_l)kT} \right\}$$

mit einer Zufallsdatensequenz $d_l'$, einer bekannten Amplitude $A_l$, einem bekannten Pulsformungsfilter $h_l$, einer bekannten Symbolzeit $T_{Sl}$ und einer bekannten Abtastzeit T beschreiben, kann der in Fig. 7 gezeigte Zusammenhang zwischen Ausgangs-Backoff *(OBO)* und $\hat{Q}_{8,4} = \frac{\hat{\kappa}_8}{(\hat{\kappa}_4)^2}$ mittels Simulation verschiedener Zufallsdatensequenzen $d'_l$ berechnet werden.

Sind solche Informationen über das Signal nicht oder nur eingeschränkt verfügbar können Signalparameter auch mittels einer Signalanalyse gewonnen werden. Bspw. können die Mittenfrequenzen ("carrier frequencies"), Bandbreiten und relativen Signalleistungen aller Träger eines von der Empfangseinheit 14 empfangenen Signals bestimmt werden. Zudem kann das Modulationsformat bestimmt werden, bspw. mit einem Kumulanten-basierten Verfahren wie in W. Su and J. A. Kosinski, "Higher Order Blind Signal Feature Separation: An Enabling technology For Battlefield Awareness", U.S. Army CERDEC, Tech. Rep., 2006. Das verstärkte Signal kann dann entsprechend der bestimmten Information simuliert und der Zusammenhang zwischen Ausgangs-Backoff *(OBO)* und $\hat{Q}_{8,4} = \frac{\hat{\kappa}_8}{(\hat{\kappa}_4)^2}$ berechnet werden.

BEZUGSZEICHENLISTE

| | |
|---|---|
| 10 | Kommunikationssystem |
| 12 | Sendeeinheit |
| 14 | Empfangseinheit |
| 16, 16a, 16b | Leistungsverstärker |
| 18a, 18b | Übertragungsstrecke |
| 20 | Recheneinheit |
| 22 | System |
| 24 | Vorrichtung |
| 26 | Empfangsantenne |
| 28 | Sendeantenne |
| 30, 30a, 30b | Filter |
| 32, 32a, 32b | Filter |
| 34a, 34b | Signalverarbeitungseinheit |
| 36 | Prozessschritt |
| 38 | Prozessschritt |

**Patentansprüche**

1. Verfahren, umfassend:

   Bestimmen (36) eines Wertes eines Maßes einer Abweichung einer Amplitudenverteilung eines durch einen zumindest zeitweise in einem nichtlinearen Verstärkungsbereich betriebenen Leistungsverstärker (16, 16a, 16b) verstärkten Signals von einer Gauß-Verteilung; und
   Steuern zumindest eines Teils eines auf dem Signal basierenden Kommunikationsprozesses auf Basis des bestimmten Wertes,
   wobei das Maß der Abweichung der Amplitudenverteilung auf Kumulanten basiert, deren Ordnung größer als 2 und gerade ist.

2. Verfahren nach Anspruch 1, ferner umfassend:
   Anpassen (38) einer mittleren Eingangsleistung des Leistungsverstärkers (16, 16a, 16b) auf Basis des bestimmten Wertes.

3. Verfahren nach Anspruch 1 oder 2, wobei das durch den Leistungsverstärker (16, 16a, 16b) verstärkte Signal ein über eine störungsbehaftete Übertragungsstrecke (18a) übertragenes Signal und insbesondere ein Funksignal ist.

4. Verfahren nach einem der Ansprüche 1 bis 3, wobei das durch den Leistungsverstärker (16, 16a, 16b) verstärkte Signal ein Mehrfachträgersignal oder ein hochvalent moduliertes Einträgersignal ist.

5. Verfahren nach einem der Ansprüche 1 bis 4, wobei eine Linearität der Leistungsverstärkung des Leistungsverstärkers (16, 16a, 16b) mit zunehmender Eingangsleistung des Leistungsverstärkers (16, 16a, 16b) abnimmt und das Anpassen der mittleren Eingangsleistung des Leistungsverstärkers (16, 16a, 16b) auf Basis des bestimmten Wertes ein Reduzieren der mittleren Eingangsleistung des Leistungsverstärkers (16, 16a, 16b) auf Basis des bestimmten Wertes umfasst.

6. Verfahren nach einem der Ansprüche 2 bis 5, wobei das Anpassen der mittleren Eingangsleistung des Leistungsverstärkers (16, 16a, 16b) auf Basis des bestimmten Wertes ein Vergleichen des bestimmten Wertes mit einem oder mehreren vorbestimmten Werten umfasst.

7. Verfahren nach Anspruch 1, wobei das Maß der Abweichung der Amplitudenverteilung von einem Verhältnis einer Potenz einer Kumulante einer ersten geraden Ordnung zu einer Potenz einer Kumulante einer zweiten geraden Ordnung abhängt, wobei die Potenz der ersten Kumulante mal der Ordnung der ersten Kumulante der Potenz der zweiten Kumulante mal der Ordnung der zweiten Kumulante entspricht.

8. Verfahren nach Anspruch 1 oder 7, wobei das Maß der Abweichung der Amplitudenverteilung linear von einem Verhältnis einer Kumulanten einer ersten geraden Ordnung zu einem Quadrat einer Kumulanten einer zweiten geraden Ordnung abhängt, wobei die erste gerade Ordnung dem Doppelten der zweiten geraden Ordnung entspricht.

9. Verfahren nach Anspruch 8, wobei die erste gerade Ordnung 8 und die zweite gerade Ordnung 4 ist.

10. System (22) zum Bestimmen eines Arbeitspunktes eines nichtlinearen Leistungsverstärkers (16, 16a, 16b), umfassend:

eine Empfangseinheit (14), eingerichtet zum Empfangen eines durch den Leistungsverstärker (16, 16a, 16b) verstärkten Signals; und
eine Recheneinheit (20), eingerichtet zum Bestimmen eines Wertes eines Maßes einer Abweichung einer Amplitudenverteilung des empfangenen Signals von einer Gauß-Verteilung, wobei zumindest ein Teil eines auf dem Signal basierenden Kommunikationsprozesses auf Basis des bestimmten Wertes gesteuert wird und wobei das Maß der Abweichung der Amplitudenverteilung auf Kumulanten basiert, deren Ordnung größer als 2 und gerade ist.

11. System (22) nach Anspruch 10, ferner umfassend den Leistungsverstärker (16, 16a, 16b), wobei das System (22) dazu eingerichtet ist, eine mittlere Eingangsleistung des Leistungsverstärkers (16, 16a, 16b) auf Basis des bestimmten Wertes zu steuern.

**Claims**

1. Method, comprising:

ascertaining (36) a value of a measure of a deviation of an amplitude distribution of a signal, amplified by a power amplifier (16, 16a, 16b) operated at least temporarily in a non-linear gain region, from a Gaussian distribution; and
controlling at least part of a communication process, based on the signal, depending on the ascertained value, wherein the measure of the deviation of the amplitude distribution is based on cumulants whose order is greater than 2 and is even.

2. Method according to Claim 1, further comprising:
adjusting (38) a mean power input of the power amplifier (16, 16a, 16b) on the basis of the ascertained value.

3. Method according to Claim 1 or 2, wherein the signal amplified by the power amplifier (16, 16a, 16b) is a signal transmitted over an interference-prone transmission line (18a) and, in particular, a radio signal.

4. Method according to any one of Claims 1 to 3, wherein the signal amplified by the power amplifier (16, 16a, 16b) is a multi-carrier signal or a high-valency modulated single-carrier signal.

5. Method according to any one of Claims 1 to 4, wherein a linearity of the power gain of the power amplifier (16, 16a, 16b) decreases with increasing input power of the power amplifier (16, 16a, 16b) and the adjustment of the mean input power of the power amplifier (16, 16a, 16b) on the basis of the ascertained value comprises a reduce of the mean input power of the power amplifier (16, 16a, 16b) on the basis of the ascertained value.

6. Method according to any one of Claims 2 to 5, wherein the adjusting of the mean input power of the power amplifier (16, 16a, 16b) on the basis of the ascertained value comprises a comparison of the ascertained value with one or more predetermined values.

7. Method according to claim 1, wherein the measure of deviation of the amplitude distribution depends on a ratio of a power of a cumulant of a first even order to a power of a cumulant of a second even order, wherein the power of the first cumulant times the order of the first cumulant is equal to the power of the second cumulant times the order of the second cumulant.

8. Method according to Claim 1 or 7, wherein the measure of the deviation of the amplitude distribution depends linearly on a ratio of a cumulant of first even order to a square of a cumulant of a second even order, wherein the first even order is equal to twice the second even order.

9. Method according to Claim 8, wherein the first even order is 8 and the second even order is 4.

10. System (22) for ascertaining an operating point of a non-linear power amplifier (16, 16a, 16b), comprising:

a receiving unit (14), configured for receiving a signal amplified by the power amplifier (16, 16a, 16b); and
a calculation unit (20), configured to ascertain a value of a measure of a deviation of an amplitude distribution of the received signal from a Gaussian distribution,
wherein at least part of a communication process based on the signal is controlled on the basis of the ascertained value and
wherein the measure of the deviation of the amplitude distribution is based on cumulants whose order is greater than 2 and is even.

11. The system (22) as claimed in claim 10, further comprising the power amplifier (16, 16a, 16b), wherein the system (22) is configured to control a mean input power of the power amplifier (16, 16a, 16b) on the basis of the ascertained value.

## Revendications

1. Procédé comprenant :

la détermination (36) d'une valeur d'une dimension d'une déviation d'une distribution d'amplitudes d'un signal amplifié par un amplificateur de puissance (16, 16a, 16b) fonctionnant au moins par moments dans un domaine d'amplification non linéaire à partir d'une distribution de Gauss ; et
la commande d'au moins une partie d'un processus de communication se basant sur le signal sur la base de la valeur déterminée,
dans lequel la dimension de la déviation de la distribution d'amplitudes se base sur des cumulants dont l'ordre est supérieur à 2 et est linéaire.

2. Procédé selon la revendication 1, comprenant en outre :
l'ajustement (38) d'une puissance d'entrée moyenne de l'amplificateur de puissance (16, 16a, 16b) sur la base d'une valeur déterminée.

3. Procédé selon la revendication 1 ou la revendication 2, dans lequel, le signal amplifié par l'amplificateur de puissance (16, 16a, 16b) est un signal transmis par un chemin de transmission (18a) soumis à des perturbations et est notamment un signal radio.

4. Procédé selon l'une des revendications 1 à 3, dans lequel le signal amplifié par l'amplificateur de puissance (16, 16a, 16b) est un signal multiporteuse ou un signal à porteuse unique modulé à haute valence.

5. Procédé selon l'une des revendications 1 à 4, dans lequel une linéarité de l'amplification de puissance de l'amplificateur de puissance (16, 16a, 16b) diminue avec une puissance d'entrée croissante de l'amplificateur de puissance (16, 16a, 16b) et l'ajustement de la puissance d'entrée moyenne de l'amplificateur de puissance (16, 16a, 16b) sur la base de la valeur déterminée comprend une réduction de la puissance d'entrée moyenne de l'amplificateur de puissance (16, 16a, 16b) sur la base de la valeur déterminée.

6. Procédé selon l'une des revendications 2 à 5, dans lequel l'ajustement de la puissance d'entrée moyenne de l'amplificateur de puissance (16, 16a, 16b) sur la base de la valeur déterminée comprend une comparaison de la valeur déterminée avec une ou plusieurs valeurs prédéterminées.

7. Procédé selon la revendication 1, dans lequel la dimension de la déviation de la distribution d'amplitudes dépend d'un rapport d'une puissance d'un cumulant d'un premier ordre linéaire sur une puissance d'un cumulant d'un deuxième ordre linéaire, où la puissance du premier cumulant multipliée par l'ordre du premier cumulant est égale à la puissance du deuxième cumulant multipliée par l'ordre du deuxième cumulant.

8. Procédé selon la revendication 1 ou la revendication 7, dans lequel la dimension de la déviation de la distribution d'amplitudes dépend de manière linéaire d'un rapport d'un cumulant d'un premier ordre linéaire sur un carré d'un cumulant d'un deuxième ordre linéaire, où le premier ordre linéaire correspond au double du deuxième ordre linéaire.

9. Procédé selon la revendication 8, dans lequel le premier ordre linéaire est égal à 8 et le deuxième ordre linéaire est égal à 4.

10. Système (22) de détermination d'un point de fonctionnement d'un amplificateur de puissance (16, 16a, 16b) non linéaire, comprenant :

une unité de réception (14) conçue pour la réception d'un signal amplifié par l'amplificateur de puissance (16, 16a, 16b) ; et
une unité de calcul (20) conçue pour la détermination d'une valeur d'une dimension d'une déviation d'une distribution d'amplitudes du signal reçu d'une distribution de Gauss, où au moins une partie d'un processus de communication se basant sur le signal est commandée sur la base de la valeur déterminée et
dans lequel la dimension de la déviation de la distribution d'amplitudes se base sur des cumulants dont l'ordre est supérieur à 2 et est linéaire.

11. Système (22) selon la revendication 10, comprenant en outre l'amplificateur de puissance (16, 16a, 16b), où le système (22) est conçu pour commander une puissance d'entrée moyenne de l'amplificateur de puissance (16, 16a, 16b) sur la base de la valeur déterminée.

**Fig. 1**

**Fig. 2**

**Fig. 3**

**Fig. 4**

BESTIMMEN EINES WERTES EINES MASSES EINER ABWEICHUNG EINER AMPLITUDENVERTEILUNG EINES DURCH DEN LEISTUNGSVERSTÄRKER VERSTÄRKTEN SIGNALS VON EINER GAUSS-VERTEILUNG

ANPASSEN EINER MITTLEREN EINGANGSLEISTUNG DES LEISTUNGSVERSTÄRKERS AUF BASIS DES BESTIMMTEN WERTES

**Fig. 5**

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- A Novel Predistorter Design for Nonlinear Power Amplifier with Memory Effects in OFDM Communication Systems Using Orthogonal Polynomials. **YITAO ZHANG ; KIYOMICHI ARAKI.** IEICE TRANSACTIONS ON ELECTRONICS. INSTITUTE OF ELECTRONICS, 01. Juli 2010, vol. E93C, 983-990
- **HAO ZHI-YONG et al.** Study of engine noise based on independent component analysis. *JOURNAL OF ZHEJIANG UNIVERSITY SCIENCE,* 01. April 2007, vol. 8 (5), 772-777
- **MAHDI MAJIDI et al.** Accurate analysis of spectral regrowth of nonlinear power amplifier driven by cyclostationary modulated signals. *ANALOG INTEGRATED CIRCUITS AND SIGNAL PROCESSING,* 12. Dezember 2012, vol. 74 (2
- **W. SU ; J. A. KOSINSKI.** Higher Order Blind Signal Feature Separation: An Enabling technology For Battlefield Awareness. *U.S. Army CERDEC, Tech. Rep.,* 2006